# EUROPEAN PATENT APPLICATION

(11) **EP 1 189 234 A1**
(43) Date of publication of application: **20.03.2002**
(21) Application number: 00830617.7
(22) Date of filing: 15.09.2000
(51) Int. Cl.: G11C 5/06

(54) **Integrated electronic device with reduced internal connections**

(71) Applicant: STMicroelectronics S.r.l., 20041 Agrate Brianza (Milano) (IT)
(72) Inventor: Campardo, Giovanni, 24128 Bergamo (IT); Micheloni, Rino, 22078 Turate (IT)
(74) Representative: Cerbaro, Elena, Dr.

(57) **Abstract**

The integrated electronic device (10) with reduced internal connections comprises a first memory device (11), having signal pins (11a, 11d), data pins (11b₁), and an enabling pin (11c) receiving a first enabling signal (CE1), and a second memory device (12) having signal pins (12a, 12d), data pins (12b₁), and an enabling terminal (12c) receiving a second enabling signal (CE2). The signal pins (12a, 12d) of the second memory device (12) are connected directly to corresponding data pins (11b₁) of the first memory device (11). In addition, the first memory device (11) comprises first connecting means (19), which can be activated selectively in order to define a current path between each signal pin (11a, 11d) and each data pin (11b₁), and the second memory device (12) comprises second connecting means (22), which can be activated selectively in order to define a current path between each signal pin (12a, 12d) and each data pin (12b₁).

## Description

The present invention relates to an integrated electronic device with reduced internal connections.

As is known, in the field of microelectronics, the requirement for increasingly miniaturisation creates various problems. One of these is associated with the connections to be formed between several integrated devices which must be assembled on a card.

The problem is applicable in particular in the case of flash cards comprising one or more memory devices and a microcontroller (ASIC or µP), which put the memory devices into communication with the exterior. The main function of the flash cards is to provide a type of solid-state hard disk for storage of data, such as music which is compressed on a compact disk. It is therefore important to be able to connect several memory devices on a single card, in order to increase the storage capacity of the flash card considerably.

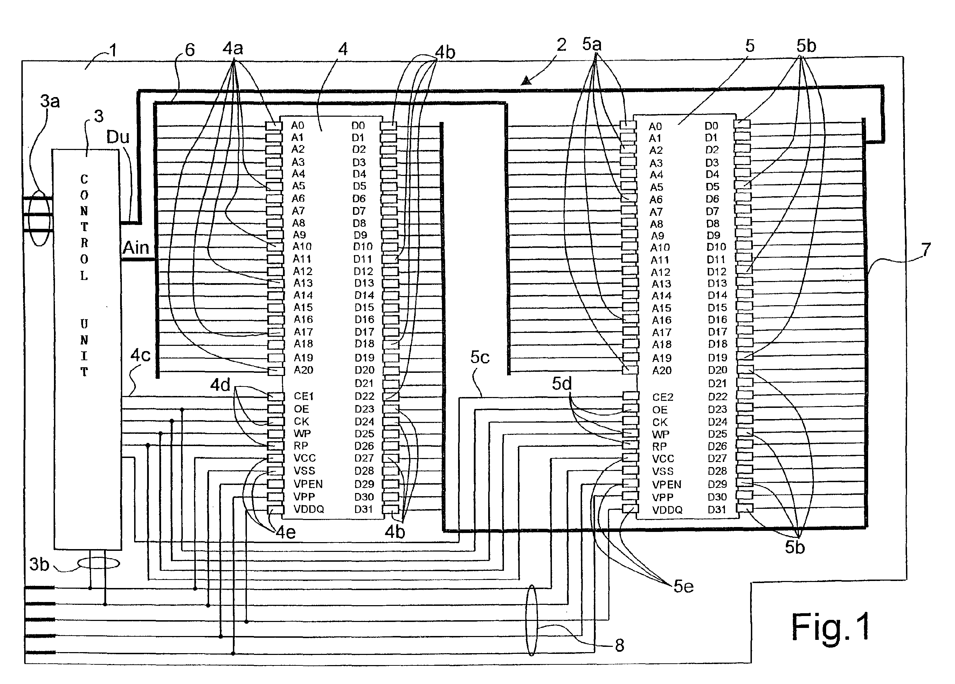

For this purpose, figure 1 shows a card 1 with a single surface, on which there is fitted an integrated electronic device 2, for example a flash card, comprising a control unit 3, for example a microcontroller, a first and a second memory device 4, 5, an address bus 6 and a data bus 7. In greater detail, each memory device 4, 5 has respective address pins 4a, 5a receiving address signals Aᵢₙ (A0-A21) generated by the control unit 3, and respective output pins 4b, 5b generating output data Dᵤ (DO-31), to be transmitted to the control unit 3. The address pins 4a of the first memory device 4 and the address pins 5a of the second memory device 5 are connected to one another and to the control unit 3, by means of the address bus 6. Similarly, the output pins 4b of the first memory device 4, and the output pins 5b of the second memory device 5 are connected to one another and to the control unit 3, by means of the data bus 7.

Each memory device 4, 5 also has an enabling pin 4c, 5c. In particular, the enabling pin 4c of the first memory device 4 receives a first enabling signal CE1, whereas the enabling pin 5c of the second memory device 5 receives a second enabling signal CE2. The two enabling signals CE1, CE2 are generated by the control unit 3 at different times, and represent the signals which distinguish the two memory devices 4, 5. Each memory device 4, 5 also has respective control pins 4d, 5d receiving control signals OE, CK, RP, WP, generated by the memory unit 3, and respective supply pins 4e, 5e connected to common supply terminals 8. The supply terminals 8 receive respective supply voltages V_{CC}, V_{SS}, V_{PEN}, V_{PP}, V_{DDQ}, which are generated outside the card 1. In addition, the control unit 3 has input/output terminals 3a which are connected to the exterior, and supply terminals 3b receiving the supply voltages V_{CC} and V_{SS}.

As can be seen in figure 1, the control unit 3 and the memory devices 4, 5 have been connected to one another without carrying out routing, which, on cards with a single surface is somewhat complex to carry out, and is not automatically guaranteed to be successful. In order to guarantee satisfactory routing, it is necessary to use multilayer cards which are somewhat costly, and are thick, and complex to test.

The technical problem on which the present invention is based consists of overcoming the limitations and disadvantages previously indicated.

According to the present invention, an integrated electronic device with reduced internal connections is provided, as defined in claim 1.

The characteristics and advantages of the electronic device according to the invention will become apparent from the following description of an embodiment provided by way of indicative, non-limiting example, with reference to the attached drawings, in which:
- figure 1 shows a general diagram of a known integrated electronic device;
- figure 2 shows a general diagram of an integrated electronic device according to the invention;
- figure 3 shows a first embodiment of the integrated electronic device in figure 2;
- figure 4 shows a second embodiment of the integrated electronic device in figure 2; and
- figure 5 shows a third embodiment of the integrated electronic device in figure 2.

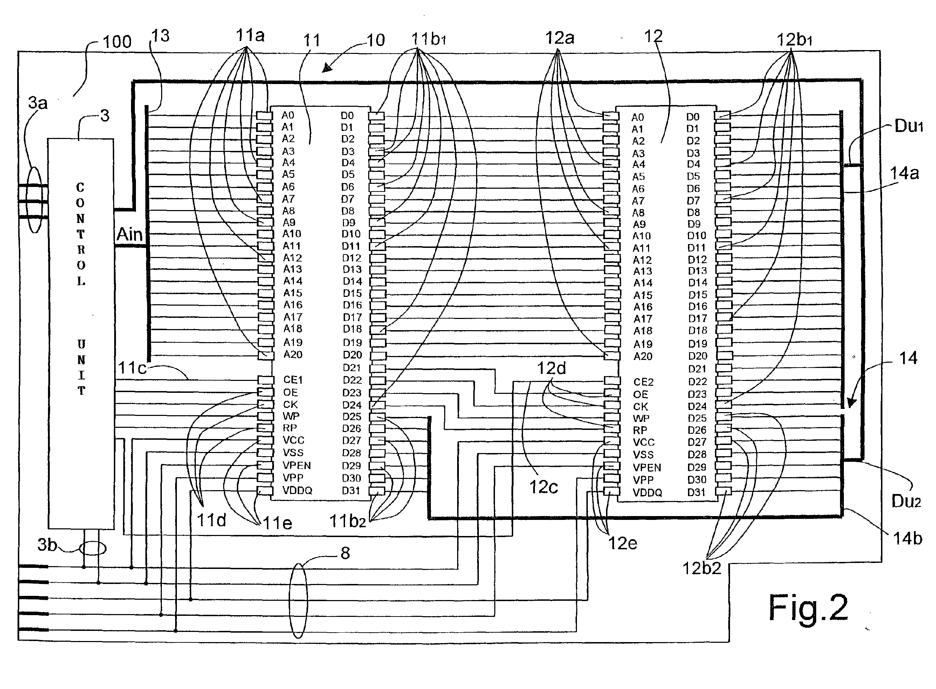

Figure 2, in which parts which are the same as those already illustrated with reference to figure 1 have been provided with the same reference numbers, and will not be described further hereinafter, shows an integrated electronic device 10, which is fitted onto a card 100 with a single surface, and comprises a first and a second memory device 11, 12, which are cascade connected to one another. For simplicity of description, figure 2 shows only two memory devices, but, in theory at least, it is possible to cascade connect any number of memory devices.

In greater detail, the first memory device 11 has: address pins 11a receiving the address signals Aᵢₙ (A0-A21), an enabling pin 11c receiving the first enabling signal CE1, control pins 11d receiving the control signals OE, CK, RP, WP, supply pins 11e connected to the common supply terminals 8, and first and second output pins 11b₁, 11b₂, to generate first output data D_{U1} (D0-D24). The address pins 11a are connected to one another and to the control unit 3 by means of an address bus 13. The second memory device 12 has address pins 12a and control pins 12d connected directly to the first output pins 11b₁ of the first memory device 11, an enabling pin 12c receiving the second enabling signal CE2, and supply pins 12e connected to the supply terminals 8. The second memory device 12 is also provided with first output pins 12b₁ connected to one another and to the control unit 3, by means of a first portion 14a of a data bus 14, and by second output pins 12b₂ connected to one another and to the second output pins 11b₂ of the first memory device 11, by means of a second portion 14b of the data bus 14. The first output pins 12b₁ and the second output pins 12b₂ generate second output data D_{U2} (D25-D31). In the example shown in figure 2, the number of the address pins 12a and of the control pins 12d of the second memory device 12 is lower than the number of the output pins 11b₁, 11b₂ of the first memory device 11, such that not all of the output pins 11b₁, 11b₂ of the memory device 11 can be used for the cascade connection of the two memory devices 11, 12. One of the tasks of the designer will therefore be to select which of the output pins of the first memory device 11 to use for the cascade connection, whereas the remaining output pins will remain connected as in figure 1.

The integrated electronic device 10 functions as follows. When the first enabling signal CE1 is at the high logic level, and the second enabling signal CE2 is at the low logic level, the first memory device 11 is switched on, and acts as a conventional memory, which generates the first output data D_{U1} at the first output pins 11b₁.

The second memory device 12 is in standby, and acts as a simple path, by means of which the first output data D_{U1} reach the control unit 3. On the other hand, when the enabling signal CE1 is at the low logic level, and the second enabling signal CE2 is at the high logic level, the first memory device 11 is in standby, and the second memory device 12 is switched on. In this situation, the first memory device 11 acts as a simple path for the address signals Aᵢₙ, and the control signals OE, CK, RP, WP generated by the control unit 3, such that the latter can reach respectively the address pins 12a and the control pins 12d of the second memory device 12. The second memory device 12 acts as a conventional memory generating second output data D_{U2}, to be transmitted to the control unit 3.

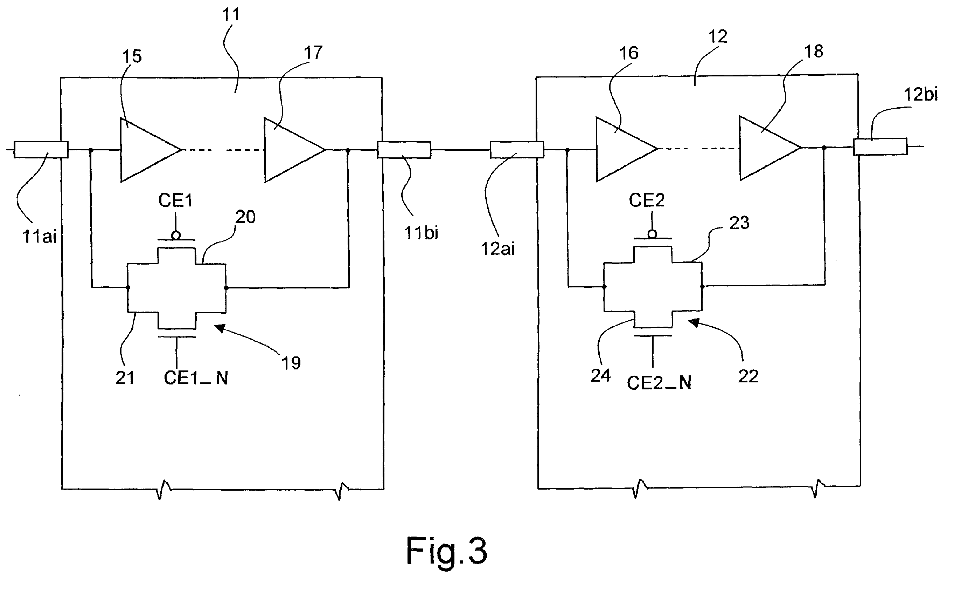

For each memory device 11, 12, figure 3 shows a specific address pin, respectively 11aᵢ and 12aᵢ connected to its own input buffer, respectively 15 and 16, and a corresponding first output pin respectively 11b₁ᵢ and 12b₁ᵢ connected to its own output buffer 17 and 18. Between respectively the input buffer 15 and the output buffer 17, and between the input buffer 16 and the output buffer 18, there is present the memory circuitry (line and column decoders, matrix, sense amplifiers etc). According to a first embodiment of the present invention, the address pin 11aᵢ and the corresponding first output pin 11b1ᵢ of the first memory device are connected to one another by means of a switch 19 of the CMOS type defining a direct path, which can be activated selectively, between the pins themselves. The switch 19 consists of a PMOS transistor 20, and an NMOS transistor 21 having first terminals connected to one another and to the address pin 11aᵢ, second terminals connected to one another and to the first output pin 11b₁ᵢ, and control terminals receiving respectively the first enabling signal CE1 and the corresponding negated signal CE1_N. Similarly, the address pin 12aᵢ and the corresponding first output pin 12b₁ᵢ of the second memory device 12 are connected to one another by means of a switch 22 of the CMOS type defining a direct path, which can be activated selectively, between the pins themselves. The switch 22 consists of a PMOS transistor 23 and an NMOS transistor 24, which have first terminals connected to one another and to the address pin 12aᵢ, second terminals connected to one another and to the first output pin 12b₁ᵢ, and control terminals receiving respectively the second enabling signal CE2 and the corresponding negated signal CE2_N.

It is apparent from the preceding description that when the first enabling signal CE1 is at the high logic level, and the second enabling signal CE2 is at the low logic level, the switch 19 is switched off, whereas the switch 22 is switched on. In this situation, the first memory device 11 acts as a conventional memory, whereas the second memory device 12 acts as a direct path between the first memory device 11 and the control unit 3. Similarly, when the first enabling signal CE1 is at the low logic level, and the second enabling signal CE2 is at the high logic level, the switch 19 is switched on, whereas the switch 22 is switched off. In this situation, the first memory device 11 acts as a direct path between the control unit 3 and the second memory device 12, whereas the second memory device 12 acts as a conventional memory.

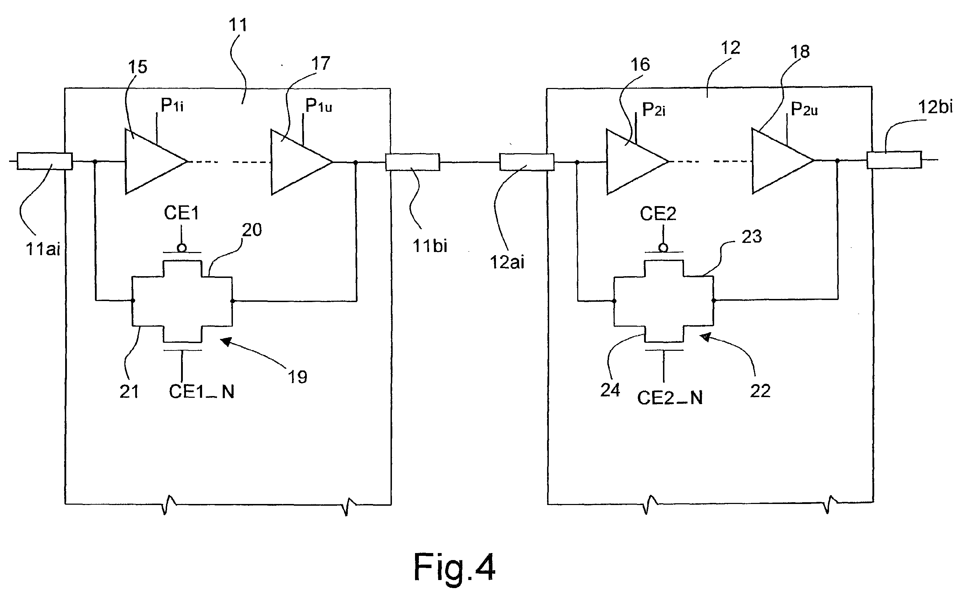

Figure 4 shows a second embodiment of the present invention, in which, in the first memory device 11, the switch 19 is connected between the address pin 11aᵢ and an input of the output buffer 17, whereas in the second memory device 12, the switch 22 is connected between the input pin 12aᵢ and an input of the output buffer 18. Figure 4 also shows that the input buffer 15 and the output buffer 17 of the first memory device 11 are driven by means of respective driving signals P1i and P1u, which are a function of the first enabling signal CE1, whereas the input buffer 16 and the output buffer 18 of the second memory device 12 are driven by means of respective driving signals P2i and P2u, which are a function of the second enabling signal CE2.

This second embodiment is more advantageous than the first embodiment, since it makes it possible to utilise the driving capacity of the output buffers 17, 18 of the two memory devices 11, 12.

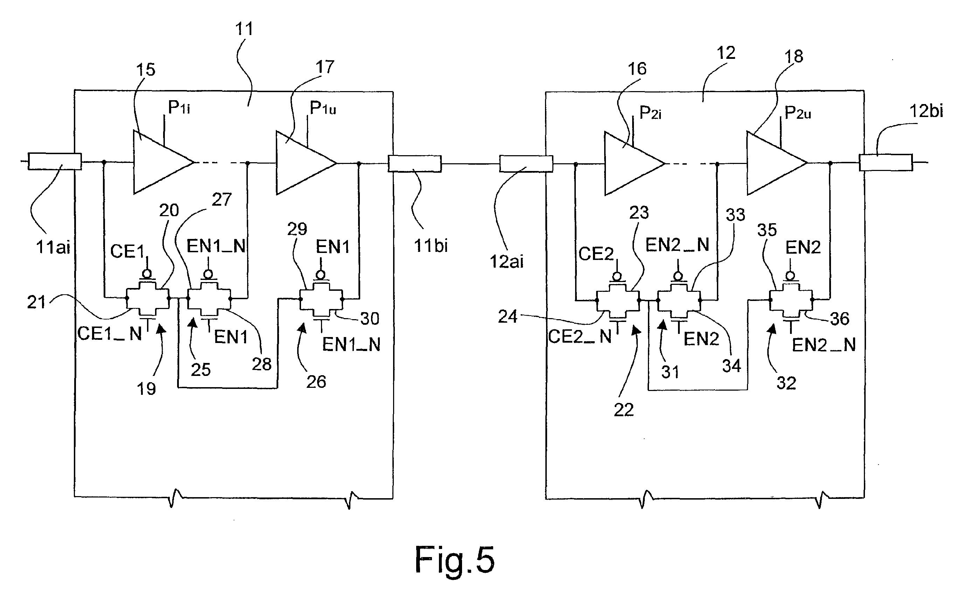

Figure 5 shows a third embodiment of the present invention, in which, in the first memory device 11, the switch 19 is connected to the first output pin 11b₁ᵢ by means of a switch 26. The switch 19 and the switch 26 define a first connection path, for connecting the first input pin 11ai directly to the corresponding output pin 11b₁ᵢ. The switch 19 is also connected to the input of the output buffer 17 by means of a switch 25. The switch 19 and the switch 25 define a second connection path connecting the first input pin 11ai to the corresponding first output pin 11b₁ᵢ, by means of the output buffer 17.

In greater detail, the switch 25 is of the CMOS type, and is formed by a PMOS transistor 27 and an NMOS transistor 28 having first terminals connected to one another and to the switch 19, second terminals connected to one another and to the input of the output buffer 17, and control terminals. The control terminal of the NMOS transistor 28 receives a first activation signal EN1, whereas the control terminal of the PMOS transistor 27 receives a corresponding negated signal EN1_N. The switch 26 is also of the CMOS type, and is formed by a PMOS transistor 29 and an NMOS transistor 30 having first terminals connected to one another and to the switch 19, second terminals connected to one another and to the first output pin 11b₁ᵢ, and control terminals. The control terminal of the PMOS transistor 29 receives the first activation signal EN1, whereas the control terminal of the NMOS transistor 30 receives the corresponding negated signal EN1_N. The first activation signal EN1 and the corresponding negated signal EN1_N are generated by a register inside the first memory device 11, and are a function of the first enabling signal CE1. Similarly, in the second memory device 12, the switch 22 is connected to the first output pin 12b₁ᵢ by means of a switch 32. The switch 22 and the switch 32 define a first connection path for connecting the first input pin 12ai directly to the corresponding first output pin 12b₁ᵢ. The switch 22 is also connected to the input of the output buffer 18 by means of a switch 31. The switch 22 and the switch 31 define a second connection path connecting the first input pin 12ai to the corresponding first output pin 12b₁ᵢ, by means of the output buffer 18.

In greater detail, the switch 31 is of the CMOS type, and is formed by a PMOS transistor 33 and an NMOS transistor 34 having first terminals connected to one another and to the switch 22, second terminals connected to one another and to the input of the output buffer 18, and control terminals. The control terminal of the NMOS transistor 34 receives a second activation signal EN2, whereas the control terminal of the PMOS transistor 33 receives the corresponding negated signal EN2_N. The switch 32 is also of the CMOS type, and is formed by a PMOS transistor 35 and an NMOS transistor 36 having first terminals connected to one another and to the switch 22, second terminals connected to one another and to the first output pin 12b₁ᵢ, and control terminals. The control terminal of the PMOS transistor 35 receives the second activation signal EN2, whereas the control terminal of the NMOS transistor 36 receives the corresponding negated signal EN2_N. The second activation signal EN2 and the corresponding negated signal EN2_N are generated by a register inside the second memory device 12, and are a function of the second enabling signal CE2.

This third embodiment of the present invention has various advantages. In particular, if the first activation signal EN1 is generated at the high logic level, and the second activation signal EN2 is generated at the low logic level, the switch 25 is switched off, whereas the switch 26 is switched on, and on the other hand the switch 31 is switched on, whereas the switch 32 is switched off. In the first memory device 11, the first connection path is therefore active, such that the first memory device 11 is connected as in figure 3. On the other hand, in the second memory device 12, the second connection path is active, such that the second memory device 12 is connected as in figure 4. This is particularly advantageous, since firstly it prevents the time delay introduced by the output buffer 16 of the first memory device 11 from being able to affect the time for access to the second memory device 12, and on the other hand the driving capacity of the output buffer 18 of the second memory device 12 is utilised. In addition, if there are several memory devices which are cascade connected to one another, it is possible to configure the last of these such that it recognises that it is the last in the cascade. For example, during the step of inspection of the cascade of memory devices, the client can insert in the last device of the cascade a flag, which allows this device to recognise that it is the last in the cascade, and therefore, by means of its internal register, to generate the corresponding activation signal at the low logic level.

The third embodiment of the present invention also has the advantage that it can be used during the reading operation of the two memory devices 11, 12. In fact, in this case, it is sufficient for it to be applied inverted, i.e. using the output buffers as input buffers, and the output pins as input pins. Buffers of a different type are then used for propagation of the signals and of the data inside the memory devices 11, 12.

The advantages which can be obtained by means of the integrated electronic device described are as follows. Firstly, the number of connections to be made on the card 1 is substantially reduced, and consequently, the routing is facilitated considerably.

In addition, the memory devices used inside the flash cards can be produced in future such as to optimise their connection, by taking advantage of the characteristics previously described. By this means, a larger number of memory devices can be inserted inside a single flash card, thus increasing its storage capacity substantially.

Finally, it is apparent that many modifications and variants, all of which come within the scope of the inventive concept, as defined in the attached claims, can be made to the integrated electronic device described and illustrated.

## Claims

1. Integrated electronic device (10) with reduced internal connections, comprising a first and a second memory device (11, 12), each having first (11a, 11d, 12a, 12d) and second (11c, 11e, 12c, 12e) input pins and first (11b₁, 12b₁) and second (11b₂, 12b₂) output pins;
**characterised in that** said first input pins (12a, 12d) of said second memory device (12) are connected to corresponding first output pins (11b₁) of said first memory device (11);
and **in that** each of said first and second memory devices (11, 12) comprises connecting means (19, 22, 25, 26, 31, 32), activated selectively, for connecting each first input pin (11a, 11d, 12a, 12d) to a corresponding first output pin (11b₁, 12b₁).

2. Device according to claim 1, **characterised in that** said connecting means (19, 22, 25, 26, 31, 32) of each of said first and second memory devices (11, 12) receive respective control signals for controlling de-activation of said connecting means, when the respective memory device (11, 12) is enabled, and activation of said connecting means, when the respective memory device (11, 12) is in stand-by.

3. Device according to claim 1 or claim 2, **characterised in that** said connecting means (19, 22) connect each first input pin (11a, 11d, 12a, 12d) directly to the corresponding first output pin (11b₁, 12b₁).

4. Device according to claim 1 or claim 2, **characterised in that** said connecting means (19, 22) connect each first input pin (11a, 11d, 12a, 12d) to the corresponding first output pin (11b₁, 12b₁), by means of an output buffer (17, 18).

5. Device according to any one of the preceding claims, **characterised in that** said connecting means (19, 22) of each of said first and second memory devices (11, 12) comprise a plurality of controlled switch means, each connecting a respective first input pin (11a, 11d, 12a, 12d) to the corresponding output pin (11b₁, 12b₁).

6. Device according to claim 5, **characterised in that** said first and second memory devices (11, 12) have respective enabling pins (11c, 12c) receiving respective enabling signals (CE1, CE2); and **in that** each of said controlled switch means is of the CMOS type and has a first and a second control terminal receiving respectively a respective enabling signal (CE1, CE2) and a respective negated enabling signal (CE1_N, CE2_N).

7. Device according to claim 1 or claim 2, **characterised in that** each of said connecting means (19, 22, 25, 26, 31, 32) define, for each of said first input pins (11a, 11d, 12a, 12d), a first and a second connection path, which are activated selectively, said first connection path connecting the respective first input pin (11a, 11d, 12a, 12d) directly to the corresponding first output pin (11b₁ 12b₁), and said second connection path connecting the respective first input pin (11a, 11d, 12a, 12d) to the corresponding first output pin (11b₁, 12b₁), by means of an output buffer (17, 18).

8. Device according to claim 7, **characterised in that** said connecting means (19, 22, 25, 26, 31, 32) comprise, for each of said first input pins (11a, 11d, 12a, 12d), first controlled switch means (19, 22), disposed along an initial common section of said first and second connection path; second controlled switch means (26, 32), disposed along said first connection path; and third controlled switch means (25, 31), disposed along said second connection path.

9. Device according to claim 8, **characterised in that** said first and second memory devices (11, 12) have respective enabling pins (11c, 12c) receiving respective enabling signals (CE1, CE2); **in that** at least said first controlled switch means (19, 22) are of the CMOS type, and have each a first and a second control terminal receiving respectively a respective enabling signal (CE1, CE2) and a respective negated enabling signal (CE1_N, CE2_N); and **in that** said second (26, 32) and third (25, 31) controlled switch means are driven in counterphase.

10. Device according to any one of the preceding claims, **characterised in that** said first input pins (11a, 11d, 12a, 12d) comprise address pins (11a, 12a); said second input pins (11c, 11e, 12c, 12e) comprise supply pins (lie, 12e) and enabling pins (11c, 12c); and said first and second output pins (11b₁, 11b₂, 12b₁, 12b₂) comprise data pins.

11. Device according to claim 10, **characterised in that** said first input pins (11a, 11d, 12a, 12d) additionally comprise control pins (11d, 12d).

12. Device according to any one of the preceding claims, **characterised in that** the second output pins (11b₂) of said first and second memory devices (11, 12) are connected to one another by means of a data bus (14b).
